# EUROPEAN PATENT APPLICATION

(11) **EP 4 184 549 A1**
(43) Date of publication of application: **24.05.2023**
(21) Application number: 21209511.1
(22) Date of filing: 22.11.2021
(51) Int. Cl.: H01J 37/28, H01J 37/305, H01J 37/02, H01J 37/21, H01J 37/30

(54) **METHOD OF IMAGING AND MILLING A SAMPLE**

(71) Applicant: FEI Company, Hillsboro, OR 97124-5793 (US)
(72) Inventor: Velcovský, Jaroslav, 5602 BS Eindhoven (NL); Vítecek, Jirí, 5602 BS Eindhoven (NL); Smolka, Radek, 5602 BS Eindhoven (NL); Pribyl, Bronislav, 5602 BS Eindhoven (NL); Pacura, Dávid, 5602 BS Eindhoven (NL); Kutálek, Jirí, 5602 BS Eindhoven (NL)
(74) Representative: Janssen, Francis-Paul

(57) **Abstract**

The invention relates to method of milling and imaging a sample. The method comprises the step of providing an imaging system, as well as a milling beam source. The method comprises the steps of milling, using a milling beam from said milling beam source, a sample to remove a layer of the sample; and ilmaging, using said imaging system, an exposed surface of the sample. As defined herein, the method further comprises the step of determining a relative position of said sample, and using said determined relative position of said sample in said milling step for positioning said sample relative to said milling beam. The relative position of said sample can be a working distance with respect to the imaging system, which can be determined by means of an autofocus procedure.

## Description

The invention relates to a method of imaging and milling a sample, as well as to an apparatus for such a method.

Such a method and apparatus are known, for example, from large area three-dimensional analysis in a charged particle microscope, wherein a focused ion beam is used for repeatedly removing a small part of the sample for repeatedly imaging the corresponding resulting exposed surface of the sample. This allows a so-called Large Volume Analysis (LVA) of the sample to be performed.

Volume analysis of samples using charged particle systems is performed using a variety of techniques and charged particle microscopes. Most of these techniques require delicate and demanding sample handling that, if not performed correctly, can provide unusable results or destruction of critical sample material. For example, conventional slice-and-view techniques may use a focused ion beam to mill away a slice of the sample to expose a surface that is imaged. This milling can damage areas of interest. Additionally, it is challenging to mill away slices with reproducible slice thicknesses.

It is therefore an object of the invention to provide a method and an apparatus with which the above mentioned drawbacks of imaging and milling a sample are alleviated or at least reduced. It is in particular an object of the invention to provide a method and an apparatus with which reliable and reproducible sample milling is obtained.

To this end, the invention provides a method as defined in claim 1. The method as defined herein comprises the steps of providing an imaging system, as well as a milling beam source. The method further comprises the steps of milling, using a milling beam from said milling beam source, a sample to remove a layer of the sample; and imaging, using said imaging system, an exposed surface of the sample. According to the invention, the method comprises the step of determining a relative position of said sample, and using said determined relative position of said sample in said milling step for positioning said sample relative to said milling beam.

By determining the relative position and using that determined relative position to reposition the sample with respect to the milling beam, it becomes possible to more accurately and reproducibly remove a layer of the sample with said milling beam. As an example, it was observed that slice thickness during a Large Volume Analysis varied during the entire experiment, which was mainly attributable to relatively small drift of the sample with a component in the gravitational direction (so-called stage z drift). By determining the relative position of the sample, it becomes possible to detect this stage z drift and correct for this stage z drift, for example by repositioning the sample by moving the sample with a component in the negative gravitational direction. The subsequent step of milling the sample will then be more accurate as the sample is positioned more accurate with respect to the milling beam, and the reproducibility of the layer thickness is increased. With this the object of the invention is achieved.

Advantageous embodiments will be described below.

In a specific embodiment, the method comprises the steps of providing a charged particle beam source, such as an electron beam source, as well as providing an ion beam source. The ion beam source is used for providing a focused ion beam for milling a sample to remove a layer of the sample. The charged particle beam source is used for providing a charged particle beam that is used for imaging an exposed surface of the sample. In this embodiment, the method comprises the step of determining a distance between said charged particle beam source and said sample, and using said determined distance in said milling step for positioning said sample relative to said focused ion beam. In this specific embodiment, the imaging system comprises a charged particle beam source; the milling beam source comprises an ion beam source; and the relative position of the sample is determined with respect to the charged particle beam source, or at least a derivative thereof. The determined position is then used for positioning (or repositioning) the sample relative to the ion beam. It is noted that in this specific embodiment, use can be made, additionally or alternatively, of a laser beam source that provides a laser beam for milling a sample to remove a layer of the sample. In this embodiment, it is conceivable that the relative position of the sample comprises the working distance.

In an embodiment, said milling beam is positioned at a milling angle with respect to said sample during said step of milling. The milling beam may be at a glancing angle with respect to said sample. The milling angle can be ranged in between 0-15 degrees, in particular in between 0-6 degrees of a surface of said sample. In a further embodiment, the angle is at least 1 degrees with respect to the surface of said sample.

In an embodiment, the milling beam is positioned at a plurality of rotational orientations during said step of milling. In this embodiment, so-called "spin milling" of the sample may be performed. The shallow angle spin milling may provide a large area of analysis, e.g., 100 µm to 1mm in diameter, and layers as thin as 2 nm may be removed per "spin mill". As used herein, spin mill refers to milling an area of a sample at a number of different rotational orientations using a shallow milling angle, e.g., 0 to 15 degrees, more in particular 1 to 10 degrees from glancing incidence, relative to the sample surface. An example of the technique includes positioning the sample so that the milling beam angle of incidence relative to the sample surface is near glancing. A brief milling beam exposure, such as a focused ion beam exposure, in an embodiment, (usually several seconds with beam currents of several nA to 2.5 uA) is performed over the desired area. The stage is rotated through a fixed angle, which is typically in the range 10-60 degrees. In some embodiments, the stage is rotated 72 degrees, for example, so that 5 sites are milled to encompass 360° of that surface. Milling five sites may reduce surface texturing artifacts, for example. Usually, this stage rotation process is repeated until a full 360° rotation of the sample has been realized. In some cases, multiple rotations may be preferred per milling cycle. As a result, the milling beam is delivered to the sample from several different azimuthal directions, which greatly reduces milling artifacts (curtaining) as compared to conventional top-down cross-sectional milling. One full rotation of milling constitutes a "slice". Alternatively, a slice may be defined by the frequency the milling is interrupted to perform imaging, such as charged particle beam imaging, in particular scanning electron microscopy (SEM). As such, a slice is usually, but not always, defined by 1 full rotation. After each slice the sample is imaged, such as with SEM imaging, wherein at least one or more regions of interest (ROIs) within the milled area are imaged.

In an embodiment, said step of determining said relative position comprises the step of determining a distance between the imaging system and the sample. This embodiment allows the so-called working distance to be determined, which working distance can then be used to reposition the sample with respect to the milling beam.

The working distance can be determined, in an embodiment, by means of a focus setting routine. The focus setting routine may be employed manually, or (semi-)automatically, for example by means of a autofocus routine. The autofocus routine may be a part of the imaging system, or may be part of a controller connected to the imaging system. The imaging system may comprise a charged particle beam source, as well as charged particle beam optics that are arranged for directing the charged particle beam emanating from the charged particle beam source to the sample. The imaging system may, in an embodiment, be a scanning electron microscope, wherein an electron beam is focused on the sample and is scanned across the surface of the sample. By using the focus setting routine, it is possible to check the focus, re-adjust the focus, and infer from the changed focus settings (if any) whether a relative repositioning of the sample needs to take place. This works in particular well for displacements of the sample that are substantially parallel to an optical axis of the imaging system, such as displacements with a component in a gravitational direction. Thus, the focus routine especially enables the detection of the aforementioned z-drift (a drift of the sample with a component in the gravitational direction, due to, for example, a z-drift of a sample stage that is arranged for holding the sample). In this case, the imaging system can be arranged to mainly operate along an optical axis that extends, in use, with a component substantially parallel to the gravitational direction.

In an embodiment, said step of determining said relative position comprises the steps of imaging said sample. The imaging can be used to determine the relative position, and based on the image a repositioning of the sample can be performed. The image can be taken by said imaging system. In an alternative embodiment, the milling beam source is arranged for generating a further imaging beam, and the further imaging beam is used for imaging said sample for determining the relative position of the sample. This imaging for determining the relative position can be done, for example, in case the milling beam source is an ion beam source, or a laser source. The imaging in this embodiment may include directing an imaging beam (or further imaging beam) towards the sample, and detecting one or more signals emanating from the sample in response to the imaging beam (or further imaging beam). This can be the detection of reflected ions or photons, for example, but detection of other signals is conceivable as well.

In an embodiment, the method comprises the step of moving said sample between said imaging step and said milling step. Moving may comprise the step of changing an angle of the sample with respect to the milling beam source. In a first angle position the imaging step may be performed for determining a relative position of the sample, after which a correction of the relative position of the sample with respect to the milling beam can be performed. The step of moving may then further comprise the step of moving the sample to a second angle position with respect to the milling beam for performing the milling step.

In an embodiment, the method comprises the step of positioning said exposed surface of said sample at an imaging angle wherein the exposed surface is substantially parallel to said milling beam for said step of imaging said sample. The imaging angle may be in between 0-1 degree, for example. This allows the user to see whether any drift of the sample has taken place, in particular drift in the z-direction (with a component parallel to the gravitational direction), provided that the milling beam source is positioned at an angle with respect to this z-direction. If z-direction drift has taken place, it will be detectable in the (further) imaging step, and the sample may be repositioned with respect to the milling beam again.

In an embodiment, the method comprises the step of moving between said milling angle for said milling step and said imaging angle for said imaging step. In practice that means moving between an angle that is ranged in between 0-15 degrees, in particular in between 0-6 degrees, and an angle that is ranged in between 0-1 degrees. In an embodiment, the milling angle is ranged in between 1-6 degrees, and the imaging angle is ranged in between 0-1 degrees. Thus, a small angular movement is used, which increases the accuracy with which the sample drift can be determined.

In an embodiment, the method comprises the step of milling, with said milling beam, the exposed surface of said sample to remove a further layer of the sample. The method may comprise the step of determining said relative position prior to removing the further layer of the sample. Additionally, or alternatively, the method may comprises the step of determining the relative position after removing the further layer of the sample. This way, a plurality of layers can be removed from the sample, wherein a plurality of sample images are obtained with the imaging system in between the removal steps, and wherein a relative position of the sample is checked and adjusted when needed. The relative position can be checked after each removal of a layer, but it is conceivable as well that the relative position is checked after removal of a predetermined amount of layers as well.

As indicated before, the milling beam source may comprise one or more of an ion beam source and a laser source. For determining the relative position, the sample can be imaged using said ion beam source or said laser source.

In all of the embodiments above, it will be understood that the step of positioning of the sample relative to said milling beam may comprise one or more of the following:
- modifying a position of the milling beam;
- pattern placement of said milling beam; and/or
- moving the sample relative to the milling beam.

Repositioning of the sample is thus a relative term, and indicates that other components may be physically moved, or adjusted otherwise, for achieving the desired effect.

According to an aspect, an apparatus as defined in claim 16 is provided. The apparatus comprises a milling beam source, such as an ion beam source or a laser source, that is arranged to provide a milling beam; an imaging system for imaging a sample; a stage arranged to hold a sample, wherein the stage is at least arranged to position the sample relative to the milling beam; and a controller coupled to or including non-transitory memory including code that, when executed by the controller, causes the apparatus to:
position the stage with respect to the milling beam;
mill, with the milling beam, a sample on the stage to remove a layer of the sample;
after milling, image, with the imaging system, an exposed surface of the sample; and
determine a relative position of said sample, and using said determined relative position of said sample in said milling step for positioning said sample relative to said milling beam. Advantages of such an apparatus have been elucidated above with respect to the method.

In an embodiment, the controller is arranged for causing the apparatus to perform the method according to any one of the embodiments as disclosed herein.
Figure 1 is an example dual-beam (DB) charged particle system in accordance with an embodiment of the present disclosure.
Figure 2A is an example side view illustration of a sample and ion beam for large area, glancing incidence FIB milling in accordance with an embodiment of the present disclosure
Figure 2 B is an example plan view of a series of mill areas of sample in accordance with an embodiment of the present disclosure.
Figure 3 is an example method 301 in accordance with an embodiment of the present disclosure.
Figure 4 is a block diagram that illustrates a computer system 419 upon which an embodiment of the invention may be implemented.

Like reference numerals refer to corresponding parts throughout the several views of the drawings.

Embodiments of the present invention are described below in the context of a dual-beam charged particle microscope configured to perform glancing angle, large area milling and imaging. The disclosed techniques may provide large area volume reconstruction data of materials of different types, and the type of material being studied may determine what ion species to use and at what ion milling energy. However, it should be understood that the methods described herein are generally applicable to a wide range of different tomographic methods and apparatus, including both cone-beam and parallel beam systems, and are not limited to any particular apparatus type, beam type, object type, length scale, or scanning trajectory.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections.

Charged particle beam microscopes come in a variety of types, such as transmission electron microscopes (TEMs), scanning electron microscopes (SEMs), focused ion beam (FIBs) microscopes, and dual-beam microscopes that include both an FIB and an SEM column, to name a few. While there are many different analysis and image acquisition techniques that can be performed using this array of microscopes, one type of analysis technique aims at obtaining an array of 2D images taken at different positions within a volume of a sample so that volume reconstruction can be performed of that volume of the sample. This technique is sometimes referred to as slice-and-view. Slice-and-view is conventionally implemented in dual-beam (DB) systems since they have the ability to both remove sample material using the FIB column and image the sample using the SEM column. While the samples may also be imaged with the FIB column, imaging with the SEM column may provide greater resolution in some instances.

The conventional slice-and-view technique includes many steps that require precision and that make the process lengthy and delicate. For example, slice-and-view requires lengthy sample preparation steps, such as excavation of large volumes of a sample around a region of interest and the need to deposit a protective layer over the region of interest. Fiducials are typically formed close to the region of interest as well to help with location detection for sample movement. Additionally, the volume of a sample analyzed by slice-and-view is typically small 50 to 100 µm in at least one dimension. For example, a large slice-and-view volume may be 100x50x50 µm in X, Y, Z, respectively, which is about 250,000 µm3. Larger volumes are possible, but the time constraint of the milling process becomes prohibitive. Smaller volumes might range down to a few thousand cubic-microns, and a targeted, high-resolution run may be 1000 µm3 or smaller. Moreover, depending on the FIB column and source used, the slice thickness may be limited to 5 nm, but may be more typically on the order of 10 nm. Other issues may arise with the ion milling of the slices, such as curtaining and non-uniformity of slice thickness. All of these issues, either on their own or in combination, make slice-and-view potentially problematic and difficult to implement effectively. Another potential limitation is that, owing to the high demands of imaging resolution and cut placement accuracy, the ion beam needs to be operated at maximum possible acceleration potential (i.e., 30 keV). However, this high energy can damage biological tissue and obscure visibility of some cellular structures. Avoidance of such damage is highly desirable, especially for soft materials.

One solution to at least some of the above discussed problems includes the determination of a relative position of the sample and using this determined relative position of the sample in said milling step for positioning (or repositioning) the sample relative to said milling beam. This may include the determination of the relative position of the sample with respect to the imaging system, for example by determining the working distance of the sample with respect to the scanning electron beam. The working distance can be determined, in an embodiment, by means of a focusing step wherein the scanning electron beam is focused on the surface of the sample, and inferring the working distance from the focus settings. The focusing may be done in an autofocus routine, for example. In a further embodiment, determining the working distance may include the imaging of the sample by means of the ion beam (or the like, such as a laser beam) with which the relative position of the sample with respect to the imaging system (scanning electron beam) may be determined as well, for example by imaging the sample in a position wherein the surface of the sample is substantially parallel to the ion beam. The image provides an indication of the working distance of the sample with respect to the imaging system. Thus, determining the working distance may be used to correct for drift of the sample, in particular in the z-direction (with a component parallel to the gravitational direction).

The above method may be combined with glancing angle incident "spin milling" of the sample. The shallow angle spin milling may provide a large area of analysis, e.g., 100 µm to 1mm in diameter, and layers as thin as 2 nm may be removed per "spin mill." As used herein, spin mill refers to milling an area of a sample at a number of different rotational orientations using a shallow milling angle, e.g., 1 to 10 degrees from glancing incidence, relative to the sample surface. An example of the technique includes positioning the sample so that the FIB angle of incidence relative to the sample surface is near glancing. A brief FIB exposure (usually several seconds with beam currents of several nA to 2.5 uA) is performed over the desired area. The stage is rotated through a fixed angle, which is typically in the range 10-60 degrees. In some embodiments, the stage is rotated 72 degrees, for example, so that 5 sites are milled to encompass 360° of that surface. Milling five sites may reduce surface texturing artifacts, for example. Usually, this stage rotation process is repeated until a full 360° rotation of the sample has been realized. In some cases, multiple rotations may be preferred per milling cycle. As a result, ion flux is delivered to the sample from several different azimuthal directions, which greatly reduces milling artifacts (curtaining) as compared to conventional top-down cross sectional milling. One full rotation of milling constitutes a "slice." Alternatively, a slice may be defined by the frequency the milling is interrupted to perform SEM imaging. As such, a slice is usually, but not always, defined by 1 full rotation. After each slice the sample is imaged, such as with SEM imaging, of one or more regions of interest (ROIs) within the milled area.

In some embodiments, the one or more ROIs may be imaged at high resolution while the surrounding area inside the milled area is imaged at a lower resolution. Of course, the entire milled area may be imaged at high resolution as well. As additional slices are removed and additional exposed surfaces are imaged, the number and location of the ROIs being tracked may change, where some ROIs may disappear due to removal (or due to extending beyond the milled area) and additional ROIs may appear due to exposure. Image recognition techniques and software may be enabled to track the various ROIs as additional slices are removed and images acquired.

In this technique, conventional fiducials associated with an ROI may not be as useful for at least a couple of reasons. One, since the total milled area is typically very large, the small fiducials would lack visibility and would not help with alignment. Plus, the fiducials would likely be milled away unless they were placed along the perimeter of the milled area, which may make them less useful. Since the fiducials would be too small to be imaged with adequate resolution, subsequent positioning accuracy in the ROIs would be poor. To overcome this problem, the relative position of the sample is determined, and in a particular embodiment the working distance is determined. By determining the working distance, it will be possible to correct any misplacement or drift of the sample (e.g. z-drift), by moving the sample relative to the FIB, or adjusting the FIB to conform to the changed placement of the sample. This way, fiducials are not required anymore.

In addition to the above discussed aspects of the technique, e.g., glancing angle, large area milling, the technique may also include variation of milling parameters, e.g., ion species, number of milling sites per rotation, ion dose per site, and milling energy, based on the sample type. For example, in the case of biological samples, a plasma FIB system operating with O+ ions is preferred, thereby generating a mixture of molecular and atomic oxygen ions, typically at 12 keV or below. If, however, xenon (Xe+) is used for biological samples, the ion energy should be kept below 5 keV. For other sample types, such as metal alloys or minerology samples, argon (Ar+) or Xe+ may be preferred, and the ion energy can range widely, from 2-30 keV for example, depending on the characteristics of the individual sample. The metal and metal alloy category may include fabricated structures, e.g., battery electrodes, flexible displays, and Integrated circuits, to name a few.

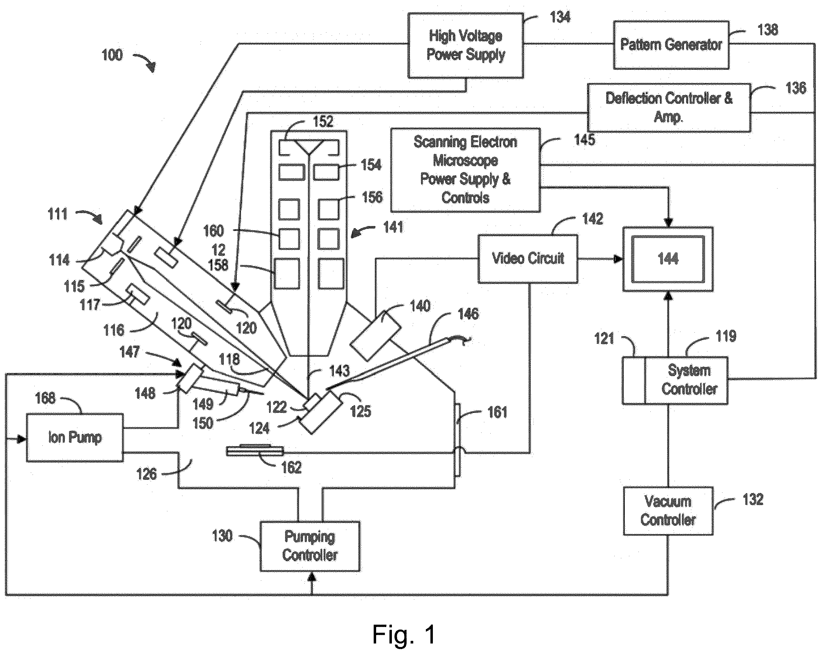

Figure 1 is an example dual-beam (DB) charged particle system 100 in accordance with an embodiment of the present disclosure. The DB system 100 includes both a focused ion beam (FIB) column and an electron column so that ion processing and/or imaging along electron imaging may be performed. In some embodiments, combinations of ion beam processing, such as milling, and electron imaging may are performed on large areas of a sample, e.g., 1 mm diameter areas, in a recursive technique so that a large volume of a sample is imaged. Such images may then be used for volume reconstruction of at least portions of the sample within the large area. While an example of suitable hardware is provided below, the invention is not limited to being implemented in any particular type of hardware.

A scanning electron microscope 141, along with power supply and control unit 145, is provided with the dual beam system 100. An electron beam 143 is emitted from a cathode 152 by applying voltage between cathode 152 and an anode 154. Electron beam 143 is focused to a fine spot by means of a condensing lens 156 and an objective lens 158. Electron beam 143 is scanned two-dimensionally on the specimen by means of a deflection coil 160. Operation of condensing lens 156, objective lens 158, and deflection coil 160 is controlled by power supply and control unit 145.

Electron beam 143 can be focused onto sample 122, which is on movable X-Y stage 125 within lower chamber 126. When the electrons in the electron beam strike substrate 122, secondary electrons are emitted. These secondary electrons are detected by secondary electron detector 140 as discussed below. STEM detector 162, located beneath the TEM sample holder 124 and the stage 125, can collect electrons that are transmitted through the sample mounted on the TEM sample holder as discussed above.

Dual beam system 100 also includes focused ion beam (FIB) system 111 which comprises an evacuated chamber having an upper neck portion 112 within which are located an ion source 114 and a focusing column 116 including extractor electrodes and an electrostatic optical system. In some embodiments, the axis of focusing column 116 is tilted 52 degrees from the axis of the electron column. Of course, other tilt angles between the FIB and SEM columns is possible as well. The ion column 112 includes an ion source 114, an extraction electrode 115, a focusing element 117, deflection elements 120, and a focused ion beam 118. Focused ion beam 118 passes from ion source 114 through focusing column 116 and between electrostatic deflection means schematically indicated at 120 toward sample 122, which can be, for example, a biological sample, a semiconductor sample, a metal or metal alloy sample, or a minerology sample, positioned on movable X-Y stage 125 within lower chamber 126. It is noted that the FIB system may be replaced, or complemented, by a laser system that is arranged for directing a laser beam to the sample, in particular with the aim of providing a milling beam for milling the sample.

Stage 125 can preferably move in a horizontal plane (X and Y axes) and vertically (Z axis). Stage 125 can also tilt approximately sixty (60) degrees and rotate about the Z axis. In some embodiments, negative stage tilts may be used to reach the desired glancing FIB milling incidence angle. Of course, both positive and negative tilts are contemplated herein. The desired tilt range for spin mill-enabled instruments is typically -38° to 60°, with 0 degrees being the "untilted," SEM-normal orientation. In some embodiments, a positive tilt of 52° is normal to the ion beam. In some embodiments, stage 125 can be cooled to cryogenic temperatures by being coupled to a cold finger (not shown), the cold finger provided or in contact with a supply of liquid nitrogen, for example. By cooling the stage 125 to cryogenic temperatures, biological samples that are cooled to cryogenic temperatures, and possibly vitrified, can be milled and imaged as discussed herein.

An ion pump 168 is employed for evacuating neck portion 112. The chamber 126 is evacuated with turbomolecular and mechanical pumping system 130 under the control of vacuum controller 132. The vacuum system provides within chamber 126 a vacuum of between approximately 1 x 10-7 Torr and 5 x 10-4 Torr. If an etch assisting, an etch retarding gas, or a deposition precursor gas is used, the chamber background pressure may rise, typically to about 1 x 10-5 Torr.

The high voltage power supply provides an appropriate acceleration voltage to electrodes in focusing column 116 for energizing and focusing ion beam 118. When it strikes substrate 122, material is sputtered, that is physically ejected, from the sample. Alternatively, ion beam 118 can decompose a precursor gas to deposit a material.

High voltage power supply 134 is connected to liquid metal ion source 114 as well as to appropriate electrodes in ion beam focusing column 116 for forming an approximately 1 keV to 60 keV ion beam 118 and directing the same toward a sample. Deflection controller and amplifier 136, operated in accordance with a prescribed pattern provided by pattern generator 138, is coupled to deflection plates 120 whereby ion beam 118 may be controlled manually or automatically to trace out a corresponding pattern on the upper surface of substrate 122. In some systems the deflection plates are placed before the final lens, as is well known in the art. Beam blanking electrodes (not shown) within ion beam focusing column 116 cause ion beam 118 to impact onto blanking aperture (not shown) instead of substrate 122 when a blanking controller (not shown) applies a blanking voltage to the blanking electrode.

In some embodiments, ion source 114 is a liquid metal ion source that typically provides a metal ion beam of gallium. The source typically is capable of being focused into a sub one-tenth micrometer wide beam at substrate 122 for either modifying the substrate 122 by ion milling, enhanced etch, material deposition, or for the purpose of imaging the substrate 122. In other embodiments, however, ion source 114 is a plasma-based ion source, such as an inductively coupled plasma source or a radio frequency ion source, and is further capable of providing different ion species, such as oxygen, argon, xenon, and nitrogen to name a few. In such an embodiment, the plasma gas is switched to provide the desired ion species. As disclosed herein, the ion species being used when operating system 100 may depend on the sample type. For example, if the sample is a biological sample, oxygen or xenon may be the desired ion species. On the other hand, if the sample is a metal, metal alloy or mineral, then the desired ion species may be argon or xenon. As disclosed herein, basing the choice of ion species on the sample type helps to efficiently and optimally process a sample to alleviate the problems discussed above, such as surface texturing for example.

A charged particle detector 140, such as an Everhart Thornley or multi-channel plate, used for detecting secondary ion or electron emission is connected to a video circuit 142 that supplies drive signals to video monitor 144 and receiving deflection signals from a system controller 119. The location of charged particle detector 140 within lower chamber 126 can vary in different embodiments. For example, a charged particle detector 140 can be coaxial with the ion beam and include a hole for allowing the ion beam to pass. In other embodiments, secondary particles can be collected through a final lens and then diverted off axis for collection.

A micromanipulator 147 can precisely move objects within the vacuum chamber. Micromanipulator 147 may comprise precision electric motors 148 positioned outside the vacuum chamber to provide X, Y, Z, and theta control of a portion 149 positioned within the vacuum chamber. The micromanipulator 147 can be fitted with different end effectors for manipulating small objects. In the embodiments described herein, the end effector is a thin probe 150.

A gas delivery system 146 extends into lower chamber 126 for introducing and directing a gaseous vapor toward substrate 122. For example, iodine can be delivered to enhance etching, or a metal organic compound can be delivered to deposit a metal.

System controller 119 controls the operations of the various parts of dual beam system 110. Through system controller 119, a user can cause ion beam 118 or electron beam 143 to be scanned in a desired manner through commands entered into a conventional user interface (not shown). Alternatively, system controller 119 may control dual beam system 110 in accordance with programmed instructions stored in a memory 121. In some embodiments, dual beam system 110 incorporates image recognition software to automatically identify regions of interest, and then the system can manually or automatically extract samples in accordance with the invention. For example, the system could automatically locate desired features on a sample.

In operation, the system 100 performs one or milling and imaging processes on sample 122, wherein an exposed layer of sample 122 is imaged after each milling process. In an embodiment, the system 100 performs a "spin milling" process on sample 122. The spin milling includes milling the sample 122 at a glancing angle and in a plurality of rotational orientations. For example, the stage 125 is tilted so that the ion beam 118 is at 1° to 10° from the surface of the sample 122 and then the surface is milled over a desired area (the desired area may be 100 µm to 1mm and may further include the entire field of view at a given magnification). After milling over the desired area, the sample 122 is rotated 72°, for example, and the sample 122 is milled again at the same glancing angle and over the same size of area. Of course, other angles of rotation may be used within 360°. This mill and rotate process may be repeated a desired number of times, such as 2, 3, 4, 5, 6 or more, and once a full 360° of rotation has occurred (or multiple rotations, if desired), the sample 122 is imaged with the electron beam 143. More specifically, after the full milling, an exposed surface of the sample 122 is imaged. The milling after the full 360° has occurred may be referred to herein as a "slice" of the sample.

The method according to the invention comprises the step of determining a relative position of the sample, and using said determined relative position of said sample in said milling step for positioning said sample relative to said milling beam. The relative position of the sample is checked and corrected before the milling step, so that it is ensured that the milling process occurs as desired.

After milling, an image of the sample 122 may be taken by means of the imaging system, for example using the electron beam 143. In some embodiments, the sample 122 may be repositioned in x, y, z and/or tilt angle to acquire these images with the electron beam 143, then repositioned to the desire glancing angle to mill another slice of the sample 122.

For the milling, the ion species used and the energy of the ion beam 118 may be based on the type of sample being milled and imaged. For example, a biological sample may be milled using O2+ at an energy of 12 keV or less, or, alternatively, be milled using Xe+ at an energy of less than 5 keV. If, for example, the sample is a metal or mineral, the ion species may be either Ar+ or Xe+ at an energy of 2 to 30 keV. Irrespective of ion species, sample and ion beam energy, the sample may also be cooled to cryogenic temperatures during milling an imaging. The cryo-cooling may be especially useful in studying biological samples, some of which may have been vitrified prior to loading into system 100, to preserve their structure. By implementing the "spin mill" process, large areas of sample 122 may be repeatedly imaged so that a volume of images may form a 3D reconstruction of the sample. Additionally, the use of the disclosed spin mill process reduces the need for depositing a protective layer, performing pre-excavations of large volumes surrounding the ROI, and depositing fiducials, which provides a straightforward and robust 3D analysis technique.

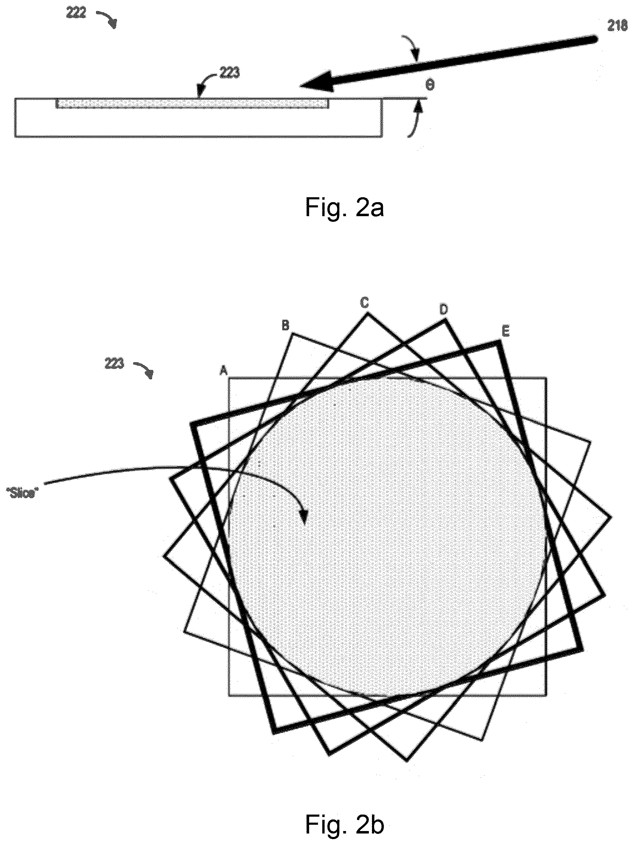

Figure 2A is an example side view illustration of a sample 222 and ion beam 218 for large area, glancing incidence FIB milling in accordance with an embodiment of the present disclosure. The illustration of Figure 2A is an example of FIB milling that could be implemented on a DB system, such as system 100. The illustration shows sample 222 being milled by an ion beam 218 at an angle Θ. The milling occurs over area 223 of the sample 222, where area 223 is shown as the dotted region. The ion beam 218 is at the angle Θ to the surface of the sample 222, wherein Θ ranges from 1° to 15°, in particular within 1° to 6°. In general, Θ is defined as a glancing angle to the sample 222. The sample 222 can be milled at the glancing angle from a plurality of different rotational orientations, such as 2, 3, 4, 5, 6, and so on, to remove a layer from area 223 (see Figure 2B for examples). Based on the ion beam 218 energy, ion beam current, and angle of the ion beam 218, the removed layer may be as thin as 2 nm, but can range from 2 to 10 nm for example. Additionally, by milling the area 223 from multiple rotational orientations, the exposed surface of area 223 may be free from defects and undesired texture, such as curtaining, which provides better images and ultimately better reconstructed 3D volumes.

Figure 2B is an example plan view of a series of mill areas 223 of sample 222 in accordance with an embodiment of the present disclosure. The series of mill areas includes mill areas A, B, C, D and E, all of which were performed by ion beam 218 with the sample at a different rotational orientation. By rotating the sample 222 between each mill operation, the series of mill areas 223 A-E forms a roughly circular area that receives the ion beam milling at each rotational orientation. This roughly circular area then forms a "slice" that exposes a subsurface area. The exposed surface may then be imaged. After imaging, the series of mills may be performed again to expose a subsequent surface for imaging. This process may be repeated as many times as desired to image a desired depth of sample 222.

Each of the mill areas A-E will be milled by delivering the ion beam 218 to each pixel in the respective square. As used herein, the term "pixel" refers to a coordinate on the sample 222 inside of a mill area that receives the ion beam 218 for a designated amount of dwell time, such as several to hundreds of microseconds, but the dwell time may depend on beam current, to mill away some of the sample 222 at that coordinate. Stated differently, each pixel receives the ion beam 218 for a desired dwell time. As can be seen, areas outside of the "slice" circle also receive the ion beam 218, but because those areas do not receive the ion beam at each rotational orientation, they may not have a full thickness of the sample 222 milled away. Additionally, each mill areas A-E may fill the entire field of view of the microscope at the given magnification of the ion column, such as ion column 111. As such, very large areas may be milled at each rotational orientation.

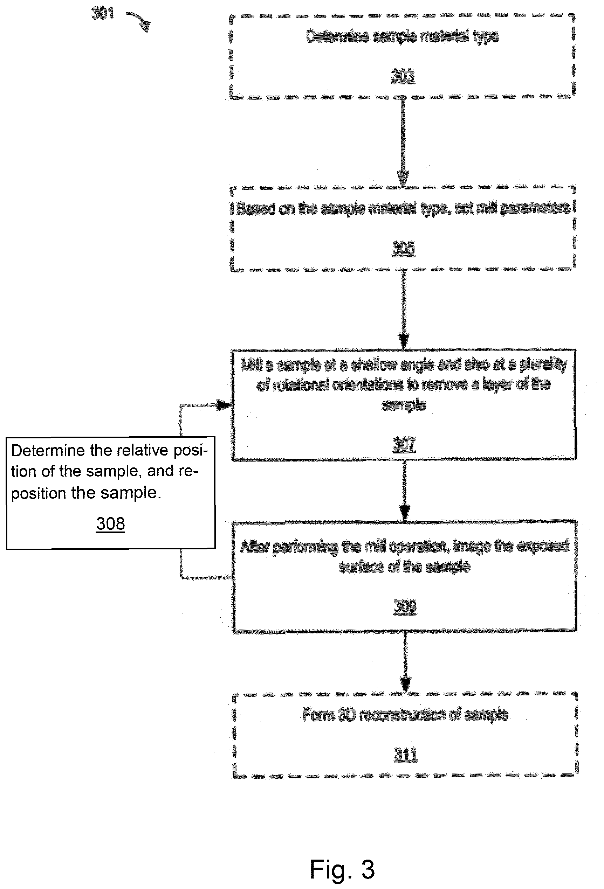

Figure 3 is an example method 301 in accordance with an embodiment of the present disclosure, which relates to "spin milling". The method 301 may be implemented on a DB system, such as system 100 for example. Method 301 may result in a series of images of a large area of a sample that has had a series of layers removed using FIB milling, such as glancing angle FIB milling. Additionally, depending on the sample material, the ion species and milling energy may be adjusted.

The method 301 begins at optional process block 303, which includes determining sample material type. For example, determinations that the sample material type is biological, metal, semiconductor, mineral, etc., may be made. In some embodiments, this determination may be made by a user. In other embodiments, the determination may be made automatically by the system using some other analytical technique, such as a spectroscopic technique. For example, a spectroscopic analysis, using EBSD for example, may be performed to determine the chemical makeup of the sample. The chemical makeup may determine whether the sample is metal/alloy, semiconductor or biological sample, which may determine mill parameters and ion species.

Process block 303 may be followed by optional process block 305, which includes setting mill parameters based on the sample material. The mill parameters may include ion species, mill energy, and ion beam current, for example. In general, the sample material type determines the mill parameters so that high surface quality milling is obtained. For example, if the sample is biological, then the selected ion species may be either oxygen or xenon. If oxygen is selected, then the ion beam energy may be set to 12 keV or less. If xenon is selected, then the ion beam energy may be set to less than 5 keV. For metal or mineral type samples, for example, the ion species can be argon or xenon, and both can be delivered at a range of energies, such as 2 keV to 30 keV.

Process block 305 may be followed by process block 307, which includes milling the sample at a shallow angle and at a plurality of rotational orientations to remove a layer of the sample. Removing the layer exposes a surface of the sample. The shallow angle may be from 1 to 15 degrees, for example, and the number of rotational orientations may be from 2 to 10. Additionally, the milling may be performed stepwise in that each rotational orientation is maintained for a desired milling time before the sample is rotated to a subsequent rotational orientation. Alternatively, the sample may be continuously rotated while being milled for a desired amount of time.

Process block 307 may be followed by process block 309, which includes imaging the exposed surface of the sample after milling. The imaging may occur after milling all of the rotational orientations or after milling each individual rotational orientation. The images may then be stored, for example.

After process block 309 is performed, method 301 may return to process block 307 so that another layer of the sample is removed by milling in the plurality of rotational orientations. This loop may be performed a plurality of times until a desired depth of the sample is imaged. As such, an image of each respective surface of the sample is obtained.

When returning into this loop, process block 307 may be followed by process block 308, which includes the step of determining a relative position of the sample, and positioning the sample relative to the focused ion beam. Process block 308 can then be followed again by process block 307 so that a layer of material is removed after checking the position of the sample.

Process block 308 may be performed each time that the loop is executed, but it is conceivable that process block 308 is only performed after a certain number of times that the loop is executed. As an example, process block 308 may be performed every fifth time that the loop is executed, thereby repositioning the sample after having removed five layers of the sample.

Process block 308 may, in an alternative embodiment, also be executed after process block 307, and before process block 309.

Optionally, process block 309 may be followed by process block 311, which includes forming a 3D reconstruction of the imaged area of the sample. Images of the plurality of exposed surfaces are combined to form the 3D reconstruction.

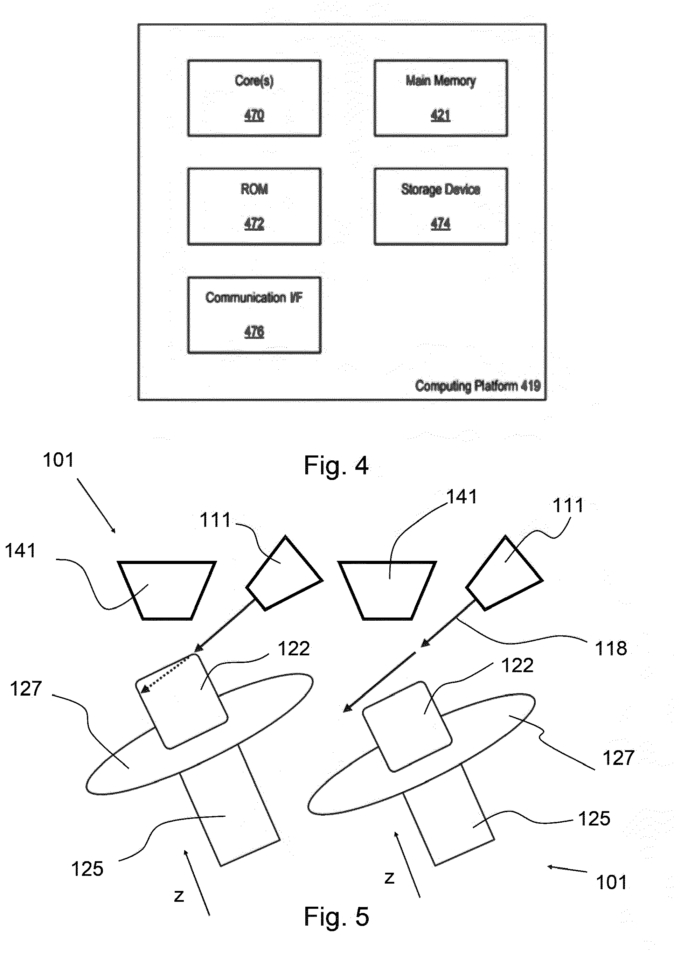

Figure 4 is a block diagram that illustrates a computer system 419 upon which an embodiment of the invention may be implemented. The computing system 419 may be an example of the system controller 119. Computer system 419 at least includes a bus or other communication mechanism for communicating information, and a hardware processor, e.g., cores, 470 coupled with the bus (not shown) for processing information. Hardware processor 470 may be, for example, a general purpose microprocessor. The computing system 419 may be used to implement the methods and techniques disclosed herein, such as method 301, and may also be used to obtain images and process said images with one or more filters/algorithms.

Computer system 419 also includes a main memory 421, such as a random access memory (RAM) or other dynamic storage device, coupled to the bus for storing information and instructions to be executed by processor 470. Main memory 421 also may be used for storing temporary variables or other intermediate information during execution of instructions to be executed by processor 470. Such instructions, when stored in non-transitory storage media accessible to processor 470, render computer system 419 into a special-purpose machine that is customized to perform the operations specified in the instructions.

Computer system 419 further includes a read only memory (ROM) 472 or other static storage device coupled to bus for storing static information and instructions for processor 470. A storage device 474, such as a magnetic disk or optical disk, is provided and coupled to a bus for storing information and instructions.

Computer system 419 may be coupled via the bus to a display, such as a cathode ray tube (CRT), for displaying information to a computer user. An input device, including alphanumeric and other keys, is coupled to the bus for communicating information and command selections to processor 470. Another type of user input device is a cursor control, such as a mouse, a trackball, or cursor direction keys for communicating direction information and command selections to processor 470 and for controlling cursor movement on the display. This input device typically has two degrees of freedom in two axes, a first axis (e.g., x) and a second axis (e.g., y), that allows the device to specify positions in a plane.

Computer system 419 may implement the techniques described herein using customized hard-wired logic, one or more ASICs or FPGAs, firmware and/or program logic which in combination with the computer system causes or programs computer system 419 to be a special-purpose machine. According to one embodiment, the techniques herein are performed by computer system 419 in response to processor 470 executing one or more sequences of one or more instructions contained in main memory 421. Such instructions may be read into main memory 421 from another storage medium, such as storage device 474. Execution of the sequences of instructions contained in main memory 421 causes processor 470 to perform the process steps described herein. In alternative embodiments, hard-wired circuitry may be used in place of or in combination with software instructions.

The term "storage media" as used herein refers to any non-transitory media that store data and/or instructions that cause a machine to operate in a specific fashion. Such storage media may comprise non-volatile media and/or volatile media. Non-volatile media includes, for example, optical or magnetic disks, such as storage device 736. Volatile media includes dynamic memory, such as main memory 732. Common forms of storage media include, for example, a floppy disk, a flexible disk, hard disk, solid state drive, magnetic tape, or any other magnetic data storage medium, a CD-ROM, any other optical data storage medium, any physical medium with patterns of holes, a RAM, a PROM, and EPROM, a FLASH-EPROM, NVRAM, any other memory chip or cartridge, content-addressable memory (CAM), and ternary content-addressable memory (TCAM).

Storage media is distinct from but may be used in conjunction with transmission media. Transmission media participates in transferring information between storage media. For example, transmission media includes coaxial cables, copper wire and fiber optics, including the wires that comprise the bus. Transmission media can also take the form of acoustic or light waves, such as those generated during radio-wave and infra-red data communications.

Computer system 419 also includes a communication interface 476 coupled to the bus. Communication interface 476 provides a two-way data communication coupling to a network link (not shown) that is connected to a local network, for example. As another example, communication interface 476 may be a local area network (LAN) card to provide a data communication connection to a compatible LAN. Wireless links may also be implemented. In any such implementation, communication interface 476 sends and receives electrical, electromagnetic or optical signals that carry digital data streams representing various types of information.

Computer system 419 can send messages and receive data, including program code, through the network(s), a network link and communication interface 476. In the Internet example, a server might transmit a requested code for an application program through Internet, ISP, local network and communication interface 476. The received code may be executed by processor 470 as it is received, and/or stored in storage device 736, or other non-volatile storage for later implementation.

Now turning to Fig. 5, an example of z-direction drift is shown, and the result it may have on milling processes. Fig. 5 schematically shows a milling and imaging system 101, comprising a scanning electron microscope 141 and a FIB 111. A sample 122 is provided on a sample holder 127 that is connected to a sample stage 125. The sample stage is movable in xyz-direction, which can be referred to using a local coordinate system with reference to the stage 125. The left-hand side of Fig. 5 shows a desired situation, wherein a milling beam 118 emanating from the FIB is able to remove a top part of the sample 122. The right-hand side of Fig. 5 shows the situation wherein the sample 122 has moved, under gravitational influences, with a component in the gravitational direction, i.e. in negative z-direction when referenced to the local coordinate system of the stage 125. In the right-hand side, the milling beam 118 is not able to remove a top part of the sample 122, and thus no milling step occurs.

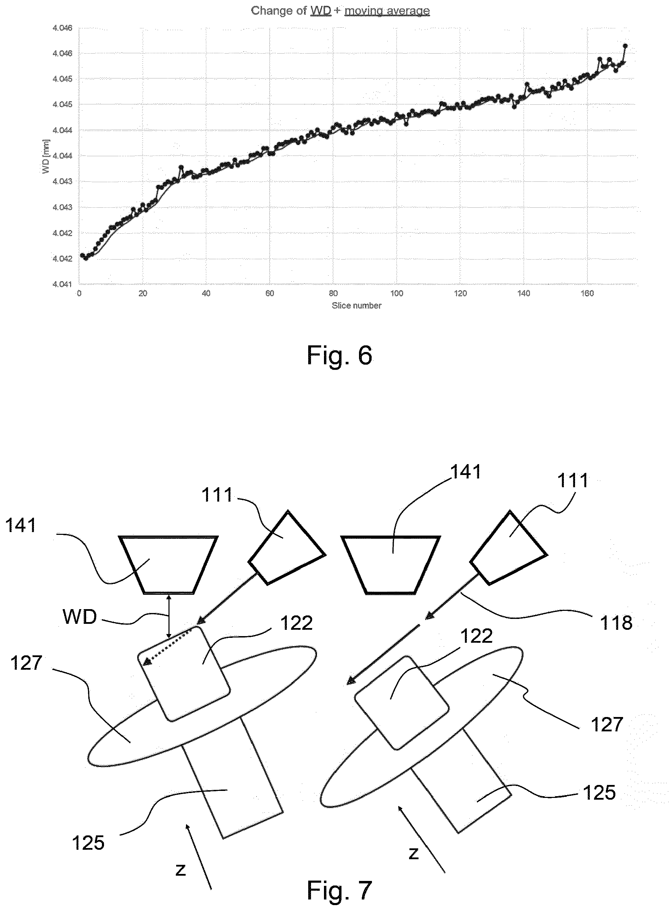

Fig. 6 shows a measure of the drift (working distance, y-axis) as a function of the slice number removed (x-axis). It can be seen that the working distance increases with the number of slices. It is noted that the working distance increases by 35 micrometer in a time interval of 21 hours (the time required to process the approximately 170 slices). This change in working distance is not linear over time, but can be compensated by measuring the relative position of the sample, in particular by measuring the working distance of the sample, and then correcting for any positive or negative change thereof. Correction may be done by moving the stage, or adjusting parameters of the milling beam, for example.

The measurement of the relative position, in particular of the working distance, may be done by performing a focus procedure. The focus procedure may be used to determine the working distance, and then the working distance can be corrected by moving the stage, for example, or the milling beam parameters may be adjusted to reflect for the changes in the working distance.

Now turning to Fig. 7, an alternative embodiment for determining the relative position of the sample, in particular for determining a measure for the working distance of the sample 122, is shown. The left-hand side of Fig. 7 shows the process of milling the sample 122 with the milling beam 118, wherein a glancing angle of 1 degree to 15 degrees, in particular 1 degree to 6 degrees, for example, is used. After milling, the sample may be rotated with respect to the FIB system 111, so that the top surface of the sample extends substantially parallel to the milling beam 118. In other words, the angle between the sample and the milling beam is substantially 0 degrees, and in particular in between 0 and 1 degrees. In this position, the ion beam system 111 can be used for imaging the sample, with which the relative z-position of the sample can be obtained, and the working distance WD can be determined as well, and corrected, if desired.

The embodiments discussed herein to illustrate the disclosed techniques should not be considered limiting and only provide examples of implementation. For example, different numbers of rotational orientations, ion species, ion beam energies and currents at various milling angles may be implemented and still fall within the scope of the present disclosure. Those skilled in the art will understand the other myriad ways of how the disclosed techniques may be implemented, which are contemplated herein and are within the bounds of the disclosure.

## Claims

1. A method comprising:
Providing an imaging system, as well as a milling beam source;
Milling, using a milling beam from said milling beam source, a sample to remove a layer of the sample; and
Imaging, using said imaging system, an exposed surface of the sample;
**Characterized by** the step of determining a relative position of said sample, and using said determined relative position of said sample in said milling step for positioning said sample relative to said milling beam.

2. A method according to claim 1, wherein said milling beam is positioned at a milling angle with respect to said sample during said step of milling, in particular wherein said milling angle is ranged in between 1-15 degrees, in particular in between 1-6 degrees from a surface of said sample.

3. A method according to claim 1 or 2, wherein said milling beam is positioned at a plurality of rotational orientations during said step of milling.

4. A method according to claim 1-3, wherein said step of determining said relative position comprises the step of determining a distance between the imaging system and the sample.

5. A method according to claim 4, wherein said distance is determined using an autofocus routine.

6. A method according to claim 1-5, wherein said step of determining said relative position comprises the steps of imaging said sample.

7. A method according to claim 6, comprising the step of moving said sample between said imaging step and said milling step.

8. A method according to claim 6 or 7, comprising the step of positioning said exposed surface of said sample at an imaging angle that is substantially parallel to said milling beam for said step of imaging said sample.

9. A method according to claim 2 and 8, comprising the step of moving between said milling angle for said milling step and said imaging angle for said imaging step.

10. A method according to claim 1-9, comprising the step of milling, with said milling beam, the exposed surface of said sample to remove a further layer of the sample.

11. A method according to claim 10, comprising the step of determining said relative position prior to removing the further layer of the sample.

12. A method according to claim 10 or 11, comprising the step of determining the relative position after removing the further layer of the sample.

13. A method according to claims 1-12, wherein said milling beam source comprises one or more of an ion beam source and a laser source.

14. A method according to claim 13 and 6, wherein, for determining the relative position, the sample is imaged using said ion beam source or said laser source.

15. A method according to claims 1-14, wherein said step of positioning said sample relative to said milling beam comprises one or more of the following:
- modifying a position of the milling beam;
- pattern placement of said milling beam; and/or
- moving the sample relative to the milling beam.

16. An apparatus comprising:
a milling beam source arranged to provide a milling beam;
an imaging system for imaging a sample;
a stage arranged to hold a sample, wherein the stage is at least arranged to position the sample relative to the milling beam; and
a controller coupled to or including non-transitory memory including code that, when executed by the controller, causes the apparatus to:
position the stage with respect to the milling beam;
mill, with milling beam, a sample to remove a layer of the sample;
after milling, image, with the imaging system, an exposed surface of the sample; and
determine a relative position of said sample, and using said determined relative position of said sample in said milling step for positioning said sample relative to said milling beam.

17. An apparatus according to claim 16, wherein said controller is arranged for causing the apparatus to perform the method according to any one of the claims 1-15.
